# EUROPÄISCHE PATENTANMELDUNG

(11) **EP 3 800 086 A1**
(43) Veröffentlichungstag der Anmeldung: **07.04.2021**
(21) Anmeldenummer: 20199369.8
(22) Anmeldetag: 30.09.2020
(51) Int. Cl.: B60L 53/66, G01R 22/06, H02J 7/00

(54) **VORRICHTUNG ZUM SIGNIEREN VON MESSWERTEN MINDESTENS EINER MESSEINHEIT**

(30) Priorität: 01.10.2019 DE 102019126540
(71) Anmelder: uesa GmbH, 04938 Uebigau-Wahrenbrück (DE)
(72) Erfinder: MORAWETZ, Frank, 01097 Dresden (DE); HEINRICH, Martin, 01217 Dresden (DE)
(74) Vertreter: Patentanwälte Olbricht, Buchold, Keulertz Partnerschaft mbB

(57) **Zusammenfassung**

Die Erfindung betrifft eine Vorrichtung (10) zum Signieren von Messwerten (32) mindestens einer Messeinheit (14) zum Messen, insbesondere von abgegebener Energie, Energieträger und/oder Medien für ein Fahrzeug, wobei die Vorrichtung (10) ein Gehäuse (11), das mindestens eine Ausgabeschnittstelle (24) zum Ausgeben von Daten und mindestens eine Kommunikationsschnittstelle (26) aufweist, und eine Prozessoreinheit (12) aufweist, wobei die Prozessoreinheit (12) mit der mindestens einen Kommunikationsschnittstelle (26) und der mindestens einen Ausgabeschnittstelle (24) in datentechnischer Verbindung steht, wobei die Prozessoreinheit (12) zum Empfangen eines signierten ersten Zeitsignals an einem ersten Zeitpunkt und eines signierten zweiten Zeitsignals an einem zweiten Zeitpunkt über die mindestens eine Kommunikationsschnittstelle (26) von einer außerhalb des Gehäuses (11) angeordneten Zeitmessvorrichtung ausgebildet ist, wobei der erste Zeitpunkt vor dem zweiten Zeitpunkt liegt, wobei die Prozessoreinheit (12) zum Empfangen von Messwerten (32) von der mindestens einen Messeinheit (14), die außerhalb des Gehäuses (11) angeordnet ist, über die mindestens eine Kommunikationsschnittstelle (26) zwischen dem ersten und zweiten Zeitpunkt ausgebildet ist, und wobei die Prozessoreinheit (12) zum Signieren der empfangenen Messwerte (32) und zum Bereitstellen der signierten Messwerte (34) über die Ausgabeschnittstelle (24) ausgebildet ist, wobei Ausgabeschnittstelle (24) logisch rückwirkungsfrei ausgebildet ist. Mit der Erfindung wird die Abgabe von Energie, Energieträgern und/oder Medien für ein Fahrzeug im öffentlichen Raum flexibel, ohne großen Aufwand und wirtschaftlich richtig organisiert.

## Beschreibung

Die Erfindung betrifft eine Vorrichtung zum Signieren von Messwerten mindestens einer Messeinheit zum Messen, insbesondere von abgegebener Energie, Energieträger und/oder Medien für ein Fahrzeug.

Die rasant ansteigende Anzahl von zumindest teilweise elektrisch angetriebenen Fahrzeugen ist mit entsprechender elektrischer Energie effizient zu versorgen. Hierfür ist eine entsprechende Infrastruktur aufzubauen. Im Moment gibt es in diesem Bereich zwei vorherrschende Systeme.

Zum einen gibt es prepaid-Verträge, bei welchen der Fahrzeughalter im Zusammenhang mit dem Kauf des Fahrzeuges oder dem Batteriesatz auch den Bezug von elektrischer Strom bezahlt, die er dann dem Netz entnehmen kann.

Zum anderen herrscht die Vorgehensweise vor, die Batterien des Fahrzeuges in der heimischen Garage aufzuladen. Im öffentlichen Raum jedoch fehlt eine flexible und faire Alternative für den Bezug von elektrischer Energie für die Fahrzeuge.

Weiter ist aus EP 3 372 442 A1 eine Speichermodullösung bekannt, bei der die Daten des Abgabevorgangs auf dem Speichermodul in der Ladesäule gespeichert werden. Wenn der Benutzer am Monatsende die Rechnung erhält, steht auf der Rechnung zu dem Abgabevorgang und der abgerechneten Energiemenge eine Identifikationsnummer. Der Benutzer kann danach zurück zur Ladesäule fahren, dort in das Speichermodul die Identifikationsnummer eingeben, und die in der Rechnung angegebene Energiemenge mit der im Speichermodul für diese Identifikationsnummer hinterlegten Energiemenge vergleichen. Dies bedingt jedoch einen hohen Aufwand für den Kunden.

Es ist daher Aufgabe der vorliegenden Erfindung, einen Vorschlag zu unterbreiten, wie die Abgabe von Energie, Energieträgern und/oder Medien für ein Fahrzeug im öffentlichen Raum flexibel, ohne großen Aufwand und wirtschaftlich richtig organisiert werden kann.

Hauptmerkmale der Erfindung sind in den Ansprüchen 1, 14 und 15 angegeben. Ausgestaltungen sind Gegenstand der Ansprüche 2 bis 13.

In einem ersten Aspekt betrifft die Erfindung eine Vorrichtung zum Signieren von Messwerten mindestens einer Messeinheit, insbesondere zum Messen abgegebener Energie, Energieträger und/oder Medien für ein Fahrzeug, wobei die Vorrichtung ein Gehäuse, das mindestens eine Ausgabeschnittstelle zum Ausgeben von Daten und mindestens eine Kommunikationsschnittstelle aufweist, und eine Prozessoreinheit aufweist, wobei die Prozessoreinheit mit der mindestens einen Kommunikationsschnittstelle und der mindestens einen Ausgabeschnittstelle in datentechnischer Verbindung steht, wobei erfindungsgemäß vorgesehen ist, dass die Prozessoreinheit zum Empfangen eines signierten ersten Zeitsignals an einem ersten Zeitpunkt und eines signierten zweiten Zeitsignals an einem zweiten Zeitpunkt über die mindestens eine Kommunikationsschnittstelle von einer außerhalb des Gehäuses angeordneten Zeitmessvorrichtung ausgebildet ist, wobei der erste Zeitpunkt vor dem zweiten Zeitpunkt liegt, wobei die Prozessoreinheit zum Empfangen von Messwerten von der mindestens einen Messeinheit, die außerhalb des Gehäuses angeordnet ist, über die mindestens eine Kommunikationsschnittstelle zwischen dem ersten und zweiten Zeitpunkt ausgebildet ist, und wobei die Prozessoreinheit zum Signieren der empfangenen Messwerte und zum Bereitstellen der signierten Messwerte über die Ausgabeschnittstelle ausgebildet ist, wobei Ausgabeschnittstelle logisch rückwirkungsfrei ausgebildet ist.

Mit der Erfindung wird damit eine Vorrichtung bereitgestellt, die Funktionen für die eichrechtskonforme Erfassung und Verarbeitung von Messdaten vereint. Die Vorrichtung dient mit der Prozessoreinheit damit als Signierungsrechner, der unabhängig von der Messeinheit arbeitet. Die Messeinheit ist außerhalb des Gehäuses der Prozessoreinheit angeordnet. Dadurch wird in der Messeinheit selbst weniger Technik verbaut, da diese lediglich die Messaufgaben durchführen und die Werte unsigniert über die Kommunikationsschnittstelle an die Prozessoreinheit übertragen kann. Zusätzlich können mehrere Messeinheiten an dieselbe Prozessoreinheit angeschlossen werden, so dass die Prozessoreinheit die Signierung der Messwerte mehrerer Messeinheiten parallel übernehmen kann. Damit können mehrere Ladepunkte mittels der Vorrichtung parallel verwaltet werden. Weiter empfängt die Prozessoreinheit signierte Zeitsignale, um den Beginn und das Ende der Messung mit hoher Genauigkeit und Sicherheit festzustellen. Mit Vorteil kann die Prozessoreinheit gleichzeitig signierte Zeitsignale von zwei unterschiedlichen Quellen empfangen. Der Empfang von Zeitsignalen von zwei verschiedenen Zeitmessvorrichtungen bewirkt, dass die Manipulation der empfangenen Zeitwerte erschwert wird. Eine Anzeigeeinheit auf der Messeinheit selbst ist nicht notwendig. Die Vorrichtung übernimmt dann die Signierung und bereitet die Werte auf, um sie einerseits auf einem Display anzuzeigen und andererseits an ein Backend zu versenden, wo die Werte für die Rechnungsstellung zur Verfügung stehen. Weiter werden die Messwerte über die Ausgabeschnittstelle signiert bereitgestellt und können von den Kunden geprüft werden, ohne dass diese zur Ladesäule zurückkehren müssen. Das Bereitstellen von Energie, Energieträgern oder Medien für Fahrzeuge im öffentlichen Raum ist damit flexibel, bedingt keinen großen Aufwand und kann wirtschaftlich richtig organisiert werden.

Unter einem Medium wird dabei z. B. Wasser, Öl, Luft bzw. Gas, Urea oder sonstiges Verbrauchs- oder Gebrauchsmaterial von Fahrzeugen verstanden.

Vorteilhafterweise kann die Prozessoreinheit zum Empfang eines der beiden signierten Zeitwerte von einem Precision Time Protocol Server ausgebildet sein. Der Precision Time Protocol Server kann weiter zum Beispiel ein Zeitserver der Physikalisch Technischen Bundesanstalt sein und damit die gesetzliche Zeit bereitstellen.

Weiter kann die Prozessoreinheit dazu ausgebildet sein, eine Authentifizierung eines Benutzers der Messeinheit und/oder des Fahrzeugs durchzuführen.

Mit dem Empfang von Zeitwerten eines Precision Time Servers wird eine unabhängige Zeitmessvorrichtung genutzt, um die Manipulationssicherheit zu erhöhen.

Weiter kann die Prozessoreinheit z. B. zum Authentifizieren von Kundendaten, Beginnen und Beenden der Abgabe von Energie, einem Energieträger und/oder einem Medium an ein Fahrzeug und zum Signieren der Messwerte (34) ausgebildet sein.

Dabei steht die Prozessoreinheit über die Kommunikationsschnittstelle des Gehäuses in datentechnischer Verbindung mit einem Schalter zum Laden der Batterie des Fahrzeugs. Die Prozessoreinheit steuert den Schalter und damit den Beginn und ggf. das Ende des Lagevorgangs. Der Abgabevorgang wird damit durch die Prozessoreinheit im Gehäuse gesteuert. Ein Start des Messvorgangs nach dem Starten des Abgabevorgangs wird damit vermieden.

Gemäß einem Beispiel kann die Ausgabeschnittstelle zum datentechnischen Verbinden mit einer Anzeigeeinheit ausgebildet sein, wobei die Prozessoreinheit zum Übermitteln von Messwerten über die Ausgabeschnittstelle an eine Anzeigeeinheit ausgebildet ist.

Damit können die von der Prozessoreinheit signierten Messwerte über die Ausgabeschnittstelle an die Anzeigeeinheit übermittelt werden. Ein Benutzer kann damit die Messwerte direkt erfassen.

Gemäß einem weiteren Beispiel kann die Ausgabeschnittstelle zum datentechnischen Verbinden mit einem externen Datenspeicher ausgebildet sein, wobei die Prozessoreinheit zum Übermitteln von signierten Messwerten über die Ausgabeschnittstelle an einen externen Datenspeicher ausgebildet ist.

Die signierten Messwerte werden damit außerhalb des Ladesäule gespeichert und stehen damit für die Rechnungsstellung und die Kontrolle durch einen Benutzer zur Verfügung.

Weiter kann die Ausgabeschnittstelle in einem weiteren Beispiel zum datentechnischen Verbinden mit einem externen Datenspeicher über einen Router ausgebildet sein.

Der externe Datenspeicher kann damit an einem anderen Ort als die Ladesäule angeordnet sein und über ein Netzwerk, z. B. das Internet, von der Prozessoreinheit die Messwerte erhalten.

In einem weiteren Beispiel kann die Vorrichtung einen internen Datenspeicher umfassen, wobei der interne Datenspeicher im Gehäuse angeordnet ist und mit der Prozessoreinheit in datentechnischer Verbindung steht, wobei der interne Datenspeicher ein digitales Schlüsselpaar bestehend aus einem öffentlichen digitalen Schlüssel und einem privaten digitalen Schlüssel zum Signieren der Messwerte aufweist.

Mit dem privaten Schlüssel signierte Messwerte können damit auf einfache Weise mittels des öffentlichen Schlüssels verifiziert werden. In einem weiteren Beispiel kann der öffentliche Schlüssel auf der Anzeigeeinheit dargestellt werden, damit ein Benutzer ihn kopieren und nach Zugang der Rechnung mittels einer Transparenzsoftware zur Verifikation der Daten auf der Rechnung nutzen kann.

Gemäß einem weiteren Beispiel kann die Vorrichtung ein Zählmodul zum Zählen der Ladevorgänge aufweisen, das in datentechnischer Verbindung mit der Prozessoreinheit steht, wobei das Zählmodul jedem Abgabevorgang eine eindeutige Zahl zuweist, wobei die Prozessoreinheit zum Übermitteln der Zahl mit den Messwerten eines Abgabevorgangs über die Ausgabeschnittstelle ausgebildet ist.

Damit wird eine zusätzlich Prüfung über die Konsistenz der Messwerte bereitgestellt, da Manipulationen auf diese Weise leichter ermittelt werden können.

Das Zählmodul kann dabei beispielsweise einen Panginierungszähler aufweisen, wobei der Panginierungszähler Zahlen als digitalen Text ausgibt.

Mittels der Speicherung der eindeutigen Zahlen als Text, der auch als String bezeichnet werden kann, wird ein arithmetischer Überlauf des Zählmoduls vermieden.

Weiter kann die Prozessoreinheit z. B. in dem Gehäuse angeordnet sein, wobei das Gehäuse vorzugsweise plombiert sein kann.

Dies erschwert zum einen den unbefugten Zugriff. Zum anderen kann ein unbefugter Zugriff auf die Komponenten, die innerhalb des Gehäuses angeordnet sind, leicht erkannt werden.

Weiter kann die Kommunikationsschnittstelle zum Beispiel zum datentechnischen Verbinden mit einer Steuer-Prozessoreinheit ausgebildet sein, wobei die Prozessoreinheit zum Empfangen eines Startsignals zum Starten des Abgabevorgangs über die Kommunikationsschnittstelle von der Steuer-Prozessoreinheit und zum Steuern der Messeinheit ausgebildet ist.

Die Prozessoreinheit erhält damit von einer Steuer-Prozessoreinheit, die beispielsweise ein Steuerrechner einer Abgabesäule sein kann, das Startsignal zum Starten des Abgabevorgangs. Die Prozessoreinheit kann dann mit dem Auslesen der Messeinheit beginnen.

Dabei kann die Prozessoreinheit in diesem Beispiel ein Startsignal zum Starten einer Messung an die Messeinheit über die Kommunikationseinheit bereitstellen und das erste Zeitsignal empfangen, wenn die Prozessoreinheit ein Startsignal zum Starten des Abgabevorgangs empfängt.

Damit wird auch das Starten des Abgabevorgangs selbst durch die Prozessoreinheit gesteuert. Die Prozessoreinheit kann damit den Abgabevorgang und den Messvorgang gleichzeitig starten. Dies vermeidet eine Verzögerung zwischen dem Start des Messvorgangs und dem Start des Abgabevorgangs, wobei durch die Verzögerung die Gefahr besteht, dass der Messvorgang erst nach dem Start des Abgabevorgangs beginnt und elektrische Energie, die zum Laden verwendet wurde, nicht durch die Messeinheit erfasst wird.

Weiter kann die Prozessoreinheit beispielsweise zum Ausgeben des ersten Zeitsignals und des zweiten Zeitsignals über die Ausgabeschnittstelle ausgebildet sein.

Damit können das erste und zweite Zeitsignal der Messung zur weiteren Verarbeitung, insbesondere zur Prüfung der Messung, verwendet werden.

In einem weiteren Beispiel kann die Vorrichtung eine Erfassungseinheit zum Erfassen der Anwesenheit eines Fahrzeugs an der Messeinheit aufweisen, wobei die Prozessoreinheit zum Empfangen eines signierten dritten Zeitsignals bei Beginn der Erfassung einer Anwesenheit und eines signierten vierten Zeitsignals bei Ende der Erfassung der Anwesenheit ausgebildet ist.

Auf diese Weise kann in Kombination mit dem dritten und vierten Zeitsignal die Dauer der Anwesenheit eines Fahrzeugs an der Messeinheit erfasst werden, um z. B. eine Parkdauer zu ermitteln. Die Erfassungseinheit kann z. B. eine Kontaktschleife sein, die an einem Parkplatz, der der Messeinheit zugeordnet ist, angeordnet ist. Weiter kann die Erfassungseinheit z. B. ein eindeutig identifizierbares Funksignal mit kurzer Reichweite von dem Fahrzeug messen und über dessen Auftauchen und Verschwinden auf die Anwesenheit des Fahrzeugs schließen.

In einem weiteren Aspekt betrifft die Erfindung ein computerimplementiertes Verfahren zum Signieren von Messwerten mindestens einer Messeinheit zum Messen, insbesondere von Energie, eines Energieträgers oder eines Mediums an ein Fahrzeug mittels einer Vorrichtung nach der vorhergehenden Beschreibung, wobei das Verfahren die folgenden Schritte aufweist: Empfangen eines signierten ersten Zeitsignals zu einem ersten Zeitpunkt und eines signierten zweiten Zeitsignals zu einem zweiten Zeitpunkt über die mindestens Kommunikationsschnittstelle mittels einer Prozessoreinheit; Empfangen von Messwerten von der mindestens einen Messeinheit über die mindestens eine Kommunikationsschnittstelle zwischen dem ersten und zweiten Zeitpunkt mittels der Prozessoreinheit; Signieren der empfangenen Messwerte mittels der Prozessoreinheit; und Bereitstellen der signierten Messwerte über die mindestens eine Ausgabeschnittstelle mittels der Prozessoreinheit.

In einem weiteren Beispiel umfasst das Verfahren weiter den Schritt: Steuern mindestens eines Schalters über die Kommunikationsschnittstelle zum Laden der Batterie der Fahrzeugs mittels der Prozessoreinheit.

Vorteile und Wirkungen sowie Weiterbildungen des Verfahrens ergeben sich aus den Vorteilen und Wirkungen sowie Weiterbildungen der oben beschriebenen Vorrichtung. Es wird daher in dieser Hinsicht auf die vorangegangene Beschreibung verwiesen.

In einem weiteren Aspekt betrifft die Erfindung ein Computerprogrammprodukt mit auf einem Computer ausführbaren Instruktionen, welche auf einem Computer ausgeführt den Computer dazu veranlassen, das Verfahren nach der vorangegangenen Beschreibung durchzuführen.

Vorteile und Wirkungen sowie Weiterbildungen des Computerprogrammprodukts ergeben sich aus den Vorteilen und Wirkungen sowie Weiterbildungen des oben beschriebenen Verfahrens. Es wird daher in dieser Hinsicht auf die vorangegangene Beschreibung verwiesen. Unter einem Computerprogrammprodukt kann z. B. ein Datenträger verstanden werden, auf dem ein Computerprogrammelement gespeichert ist, das für einen Computer ausführbare Instruktionen aufweist. Alternativ oder zusätzlich kann unter einem Computerprogrammprodukt beispielsweise auch ein dauerhafter oder flüchtiger Datenspeicher, wie Flash-Speicher oder Arbeitsspeicher, verstanden werden, der das Computerprogrammelement aufweist. Weitere Arten von Datenspeichern, die das Computerprogrammelement aufweisen, seien damit jedoch nicht ausgeschlossen.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:
- Fig. 1: eine schematische Darstellung der Vorrichtung in einer Ladesäule;
- Fig. 2: eine schematische Darstellung des Messvorgangs;
- Fig. 3: eine schematische Darstellung der Datenübertragung; und
- Fig. 4: ein Flussdiagramm des Verfahrens.

Das im Folgenden erläuterte Beispiel bezieht sich auf die Abgabe von elektrischer Energie. Alternative Beispiele, die sich auf andere Energieformen, Energieträger oder andere Medien beziehen, werden damit nicht ausgeschlossen.

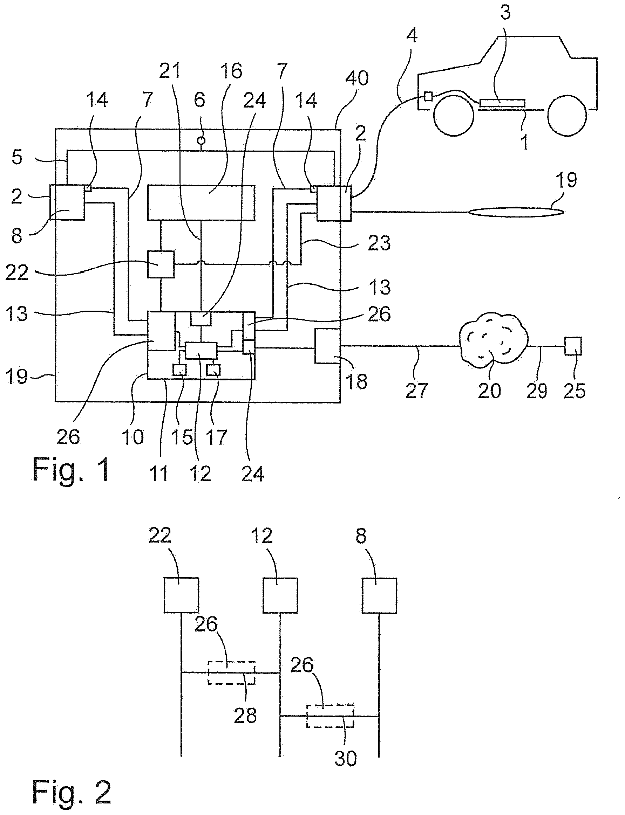

Figur 1 zeigt eine Ladesäule 40, die dafür vorgesehen ist, ein Fahrzeug 1 mit elektrischer Energie, die über eine Stromleitung 4 zugeführt bzw. zur Verfügung gestellt wird, zu versorgen. Hierbei sollen die Batterien 3 des Fahrzeugs 1 bei Bedarf mit mithilfe der Ladesäule 40 geladen werden.

Die Ladesäule 40 besitzt dabei einen Steckkontakt 2, an welchem eine Stromleitung 4 ansteckbar ist, die eine Verbindung der Ladesäule 40 mit dem Fahrzeug 1 herstellt. Vorzugsweise ist der Steckkontakt 2 Teil der Ladesäule 40. Zur Ladesäule 40 zählen ein Schalter 8 und eine Messeinheit 14, die in Reihe geschaltet zwischen der Stromleitung 5 und dem Steckkontakt 2 angeordnet ist.

In einem separaten Gehäuse 11 ist eine Prozessoreinheit 12 angeordnet. Das Gehäuse 11 umfasst eine Ausgabeschnittstelle 24 und eine Kommunikationsschnittstelle 26, die beide in datentechnischer Verbindung zu der Prozessoreinheit 12 stehen. Über die Ausgabeschnittstelle 24 und die Kommunikationsschnittstelle 26 kann die Prozessoreinheit 12 damit in datentechnische Verbindung zu Komponenten außerhalb des Gehäuses 11 gebracht werden. Damit umfasst die Vorrichtung 10 außer der Prozessoreinheit 12, die Kommunikationsschnittstelle 26 zu den Messeinheiten 14, und die Ausgabeschnittstelle 24 zum Backend und zur Ausgabeeinheit 16. Die Ausgabeeinheit 16 kann z. B. ein Display sein.

Über den Schalter 8, der datentechnisch über die Datenleitung 13 und die Kommunikationsschnittstelle 26 mit der Prozessoreinheit 12 verbunden ist, wird der Ladeprozess gesteuert, das heißt bei geschlossenem Schalter fließt Strom, bei geöffnetem nicht.

Im Fall, dass der Schalter 8 geschlossen ist und Energie zum Laden der Batterien des Fahrzeugs 1 fließt, wird die hierbei gelieferte Energiemenge von dem Messeinheit 14 ermittelt und über die Messwerteleitung 7 an den Prozessoreinheit 12 übermittelt.

Die Prozessoreinheit 12 kann mit dem Gehäuse 11, wie die Messeinheit 14 und auch die Steuer-Prozessoreinheit 22 Teil der Ladesäule 40 sein. Alternativ kann die Prozessoreinheit 12 mit dem Gehäuse 11 einen Nachrüstsatz bilden, der nachträglich in die Ladesäule eingebaut wurde. Über die Kommunikationsschnittstelle 26 wird beim Einbau dann eine datentechnische Verbindung zu der Steuer-Prozessoreinheit 22 und der mindestens einen Messeinheit 14 bereitgestellt und die Ausgabeschnittstelle 24 datentechnisch mit einer ggf. vorhandenen Anzeigeeinheit 16 und einem externen Datenspeicher 20 bzw. einem Router 18 verbunden.

Die Messeinheit 14 steht dabei über die Kommunikationsschnittstelle 26 im kontinuierlichen datentechnischen Austausch mit der Prozessoreinheit 12. Es werden laufend die relevanten Zählerstände bzw. Energielieferungen von der Messeinheit 14 über die Messwerteleitung 7 an die Prozessoreinheit 12 geliefert.

Der Prozessoreinheit 12 ist datentechnisch über die Ausgabeschnittstelle 24 und die Anzeigeleitung 21 mit der Anzeigeeinheit 16 verbunden. Auf der Anzeigeeinheit 16 werden verschiedene Informationen, die von der Messeinheit 14 ermittelt und gegebenenfalls vom Prozessoreinheit 12 aufbereitet sind, angezeigt. Hierzu zählen zum Beispiel der Zähleranfangstand der Messeinheit 14, der Zählerendstand der Messeinheit 14 und gegebenenfalls die Differenz daraus, die gelieferte Energiemenge, die in das Fahrzeug 1 geflossen ist.

Des Weiteren ist die Prozessoreinheit 12 datentechnisch auch über die Kommunikationsschnittstelle 26 mit der Steuer-Prozessoreinheit 22 verbunden.

Weiter empfängt die Prozessoreinheit 12 Zeitsignale von einem Precision Time Protocol Server. Dabei erfasst die Prozessoreinheit 12 zu einem ersten Zeitpunkt ein signiertes erstes Zeitsignal und zu einem zweiten Zeitpunkt ein signiertes zweites Zeitsignal. Die Zeitsignals umfassen dabei absolute Zeitangaben. Weiter kann der erste Zeitpunkt der Start-Zeitpunkt einer Messung und der zweite Zeitpunkt der End-Zeitpunkt einer Messung sein. Dabei können das erste und zweite Zeitsignal von einem Precision Time Protocol Server, vorzugsweise einem Server der Physikalisch Technischen Bundesanstalt ausgesendet und von der Prozessoreinheit 12 empfangen werden.

In dem hier gezeigten Ausführungsbeispiel wird über die Identifikationsleitung 23 die ID-Nummer des Fahrzeugs 1, das über die Verbindungsleitung 4 an dem Steckkontakt 2 angeschlossen ist, ausgelesen. Anstelle der Identifikationsleitung 23 ist aber auch natürlich eine Funkverbindung oder Ähnliches möglich.

Die Abrechnungsstelle 25 übernimmt dabei zentrale Aufgaben, sie hält zum Beispiel alle Kundendaten für Authentifizierungszwecke vor. Über die Datenverbindung 27, 29 und das Backend, das einen externen Datenspeicher 20 aufweisen kann, werden daher zum einem die Authentifizierung durchgeführt und hernach die Liefermengen an elektrischer Energie an die Abrechnungsstelle 25 übergeben.

Die Vorrichtung 10 weist weiter eine Erfassungseinheit 19 zum Erfassen einer Anwesenheit eines Fahrzeugs 1 an der Messeinheit 14 auf. Die Erfassungseinheit 19 kann z. B. eine Kontaktschleife sein, die an einem Parkplatz, der der Messeinheit 14 zugeordnet ist, angeordnet ist. Weiter kann die Erfassungseinheit 19 z. B. ein eindeutig identifizierbares Funksignal mit kurzer Reichweite von dem Fahrzeug 1 messen und über dessen Auftauchen und Verschwinden auf die Anwesenheit des Fahrzeugs 1 schließen.

Über die Zeit der Anwesenheit des Fahrzeugs 1 an der Messeinheit 14 kann dann auf eine Parkdauer geschlossen werden. Diese kann in der Abrechnungsstelle 25 oder einer anderen Abrechnungsstelle erfasst und dem Nutzer der Vorrichtung in Rechnung gestellt werden.

Die Einheit von Prozessoreinheit 12 und Gehäuse 11 wird auch als Messkapsel bezeichnet.

Die Messkapsel hat dabei u. a. folgende Aufgaben bzw. Funktionen:
- Auslesen des Zählers d.h. der Messeinheit 14 über die Kommunikationsschnittstelle 26
- Signieren und Bereitstellen der Zählerwerte über die Ausgabeschnittstelle 24 und
- Übermitteln der Zählerwerte über die Ausgabeschnittstelle 24 an die Anzeigeeinheit 16.

Weiter kann über die Messkapsel auch der Abgabevorgang über den Schalter 8 gesteuert werden.

Die Ladesäule 40 ist so ausgebildet, dass mit ihr nicht nur ein Fahrzeug 1 zu laden ist, sondern über eine Mehrzahl von Steckkontakten 2 auch eine Mehrzahl von Fahrzeugen 1 an verschiedenen Ladepunkten geladen werden können. Die Ladesäule 40 ist also geeignet, mehrere Fahrzeuge 1 gleichzeitig mit Energie zu versorgen. Daher werden auf der Anzeigeeinheit 16 die Zählerstände bzw. Verbrauchsinformation der verschiedenen Ladepunkte angezeigt.

Zusätzlich wird auf der Anzeigeeinheit 16 der Stationsname, ein Zeitstempel (Datum, Uhrzeit) und auch eine datentechnische Signatur (gegebenenfalls auch in einem QR-Code) angezeigt, um dem Benutzer maximale Transparenz zu bieten.

Die Steuer-Prozessoreinheit 22 hat die Aufgabe, die Benutzerschnittstelle, z. B. auf der Anzeigeeinheit, zu steuern und der Prozessoreinheit 12 den Start der Ladevorgänge anzuweisen. Sie gibt gegebenenfalls Zeitvorgaben der Abrechnungsstelle 25 an die Messkapsel weiter. Auch sorgt die Steuer-Prozessoreinheit 22 für eine Synchronisation der Systemzeit mit der Prozessoreinheit 12.

Dabei stellt die Ladesäule 40, insbesondere die Messkapsel, ein Gerät zum eichrechtskonformen Erfassen, Signieren und Versenden von Daten zur Abrechnung der Ladevorgänge von Elektrofahrzeugen aller Art dar.

Diese Messkapsel arbeitet in Verbindung mit unterschiedlichen MID-geeichten Zählern, Wechselstrom, Drehstrom, Gleichstrom, direktmessend oder mit Messwandlern. Auch Zähler ohne eigene Anzeige wären denkbar. Die Anzahl der Zähler ist nicht begrenzt.

Das Auslesen und die Signatur des Datensatzes (Abrechnungsdaten und/oder kundenrelevante Daten) wird durch die Prozessoreinheit 12 durchgeführt. Dabei kann das Gehäuse 11, in dem die Prozessoreinheit 12 angeordnet ist, plombiert sein.

Die Vorrichtung 10 kann in alle Vorrichtungen zur Beladung von Elektrofahrzeugen mit eichrechtskonformen Zählerplatz eingebaut werden.

Die Daten werden beim Auslesen aus dem Zähler sofort signiert versendet oder zwischengespeichert. Die Versendung erfolgt an ein zugelassenes Backend. Dort werden die Daten verschlüsselt gespeichert. Kunden können sich Ihre Daten von dort anfordern und mit der öffentlichen Transparenzsoftware dekodieren.

Von großer Bedeutung ist in diesem Zusammenhang, dass bei der Erfindung gemäß vorgeschlagener Anordnung ein hohes Maß an Datensicherheit vorgehalten wird.

Hierzu ist beispielsweise vorgesehen, dass im Herstellungsprozess der Messkapsel ein Schlüsselpaar aus privatem Schlüssel und öffentlichem Schlüssel (Private-Key und Public-Key) auf der Messkapsel insbesondere in einem internen Datenspeicher 17 erzeugt wird, der mit der Prozessoreinheit 12 in datentechnischer Verbindung steht.

Der Private-Key wird dabei auf der Messkapsel so hinterlegt, dass er nur auslesbar ist, wenn das Siegel/Plombierung des Gehäuses 11 zerstört wird und der interne Datenspeicher 17, der z. B. eine Festplatte sein kann, ausgebaut und ausgelesen wird.

Der Private-Key liegt ausschließlich auf der Messkapsel und ist niemand anderem außerhalb der Messkapsel bekannt.

Der Public-Key dagegen ist über die rückwirkungsfreie Ausgabeschnittstelle 24 auslesbar und wird separat, bei einer dritten Stelle, der Qualitätsstelle, hinterlegt, wo er der jeweiligen Messkapsel eindeutig zugeordnet wird.

Bei der Erzeugung von Messwerten, werden auf der Messkapsel die ausgelesenen Zählerwerte mittels des Private-Key signiert und anschließend über die rückwirkungsfrei über die Ausgabeschnittstelle bereitgestellt. Ebenso wird der Public-Key über die Anzeigeeinheit 16 angezeigt und als "QR-Code" dargestellt. Anschließend ist es möglich, mittels des Public-Keys die Echtheit der Messwerte zu verifizieren.

Damit sichergestellt werden kann, dass die Software auf der Messkapsel nicht manipuliert wurde, ist die Software auf der Messkapsel mit einem, auf dem bei der Qualitätsstelle hinterlegten Private-Key, signiert.

Während des Bootprozesses der Messkapsel wird mithilfe des Public-Key schließlich sichergestellt, dass die zu startende Software auf dem internen Datenspeicher 17 eine valide Signatur hat und nicht manipuliert wurde.

Um die Software der Messkapsel mit Updates zu versehen, wird über eine Kommunikationsschnittstelle 26 zur Messkapsel eine Datei bereitgestellt. Diese Datei muss ebenfalls mit dem Private-Key der Qualitätsstelle signiert sein.

Diese Signatur wird mit dem auf der Messkapsel hinterlegten Public-Key geprüft und nach Freigabe wird das Update ausgeführt.

Figur 2 zeigt schematisch die Signalübertragung beim Start eines Abgabevorgangs. Zunächst wird durch die Steuer-Prozessoreinheit 22 ein Startsignal 28 zum Messung ausgegeben und über die Kommunikationsschnittstelle 26 an die Prozessoreinheit 12 übermittelt. Bei Empfang des Startsignals 28 der Messung startet die Prozessoreinheit 12 die Ermittlung der Messwerte über die Messeinheit 14. Weiter übermittelt die Prozessoreinheit 12 ein Startsignal 30 zum Laden an den Schalter 8. Der Schalter 8 stellt dann eine elektrische Verbindung zwischen der Energiequelle 6 und der Messeinheit 14 bzw. dem Steckkontakt 2 her.

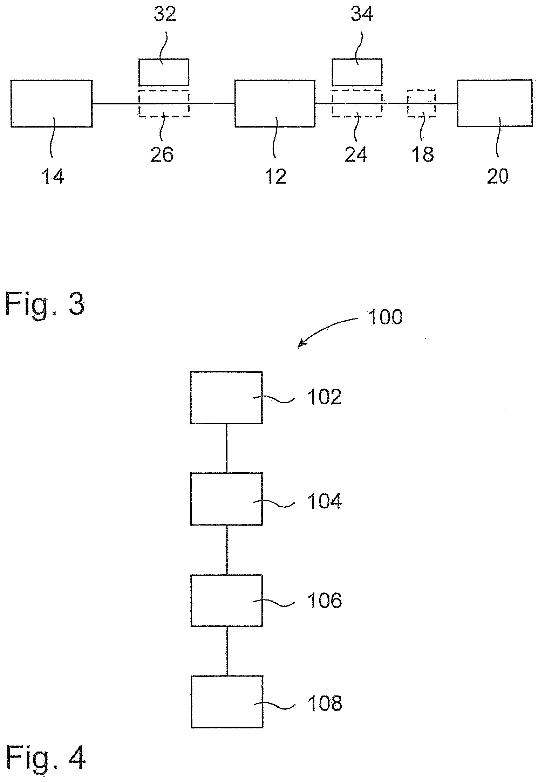

Figur 3 zeigt schematisch den Übertragungsweg der Messwerte 32 von der Messeinheit 14 bis zum externen Datenspeicher 17.

Die Messwerte 32 werden von der Messeinheit 14 bereitgestellt und über die Kommunikationsschnittstelle 26 an die Prozessoreinheit 12 übertragen. Die Prozessoreinheit 12 signiert die Messwerte 32 und erzeugt damit signierte Messwerte 34. Die signierten Messwerte 34 werden über die Ausgabeschnittstelle 24, ggf. weiter über den Router 18, an den externen Datenspeicher 20 übermittelt.

Figur 4 zeigt ein Flussdiagramm des computerimplementierten Verfahrens 100 zum Signieren von Messwerten mindestens einer Messeinheit für elektrische Leistung bei einem Abgabevorgang von elektrischer Energie an eine Batterie eines Fahrzeugs mittels einer Vorrichtung 10.

In einem ersten Schritt 102 umfasst das Verfahren 100 das eines signierten ersten Zeitsignals zu einem ersten Zeitpunkt und eines signierten zweiten Zeitsignals zu einem zweiten Zeitpunkt über die mindestens Kommunikationsschnittstelle mittels einer Prozessoreinheit. Die Zeitsignale können dabei von einem Precision Time Protokoll Server erstellt werden, der außerhalb des Gehäuses der Prozessoreinheit angeordnet ist.

In einem zweiten Schritt 104 werden Messwerte 32 von der mindestens einen Messeinheit über die mindestens eine Kommunikationsschnittstelle zwischen dem ersten und zweiten Zeitpunkt mittels der Prozessoreinheit empfangen. Die Messwerte 32 werden dabei von der Messeinheit, die außerhalb des Gehäuses der Prozessoreinheit angeordnet ist, erstellt und messen die über den Steckkontakt abgerufene elektrische Energie.

Weiter kann mindestens ein Schalter über die mindestens eine Kommunikationsschnittstelle zum Laden der Batterie der Fahrzeugs mittels der Prozessoreinheit angesteuert werden. Die Prozessoreinheit startet damit den Ladevorgang für die Batterie des Fahrzeugs.

Ein dritter Schritt 106 umfasst das Signieren der Messwerte 32, die von der Prozessoreinheit empfangen werden. Die Prozessoreinheit signiert die Messwerte 32 und erstellt dabei signierte Messwerte 34.

Die signierten Messwerte 34 werden in einem weiteren Schritt 108 über die mindestens eine Ausgabeschnittstelle von der Prozessoreinheit bereitgestellt. Dabei können die signierten Messwerte einer Anzeigeeinheit 16 und einem externen Datenspeicher 20 bereitgestellt werden.

Die Erfindung ist nicht auf eine der vorbeschriebenen Ausführungsformen beschränkt, sondern in vielfältiger Weise abwandelbar.

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

Die jetzt mit der Anmeldung und später eingereichten Ansprüche sind ohne Präjudiz für die Erzielung weitergehenden Schutzes.

Sollte sich hier bei näherer Prüfung, insbesondere auch des einschlägigen Standes der Technik, ergeben, dass das eine oder andere Merkmal für das Ziel der Erfindung zwar günstig, nicht aber entscheidend wichtig ist, so wird selbstverständlich schon jetzt eine Formulierung angestrebt, die ein solches Merkmal, insbesondere im Hauptanspruch, nicht mehr aufweist. Auch eine solche Unterkombination ist von der Offenbarung dieser Anmeldung abgedeckt.

Es ist weiter zu beachten, dass die in den verschiedenen Ausführungsformen beschriebenen und in den Figuren gezeigten Ausgestaltungen und Varianten der Erfindung beliebig untereinander kombinierbar sind. Dabei sind einzelne oder mehrere Merkmale beliebig gegeneinander austauschbar. Diese Merkmalskombinationen sind ebenso mit offenbart.

Die in den abhängigen Ansprüchen angeführten Rückbeziehungen weisen auf die weitere Ausbildung des Gegenstandes des Hauptanspruches durch die Merkmale des jeweiligen Unteranspruches hin. Jedoch sind diese nicht als ein Verzicht auf die Erzielung eines selbständigen, gegenständlichen Schutzes für die Merkmale der rückbezogenen Unteransprüche zu verstehen.

Merkmale, die nur in der Beschreibung offenbart wurden oder auch Einzelmerkmale aus Ansprüchen, die eine Mehrzahl von Merkmalen umfassen, können jederzeit als von erfindungswesentlicher Bedeutung zur Abgrenzung vom Stande der Technik in den oder die unabhängigen Anspruch/Ansprüche übernommen werden, und zwar auch dann, wenn solche Merkmale im Zusammenhang mit anderen Merkmalen erwähnt wurden beziehungsweise im Zusammenhang mit anderen Merkmalen besonders günstige Ergebnisse erreichen.

## Patentansprüche

1. Vorrichtung zum Signieren von Messwerten (32) mindestens einer Messeinheit (14) zum Messen, insbesondere von abgegebener Energie, Energieträger und/oder Medien für ein Fahrzeug, wobei die Vorrichtung (10) ein Gehäuse (11), das mindestens eine Ausgabeschnittstelle (24) zum Ausgeben von Daten und mindestens eine Kommunikationsschnittstelle (26) aufweist, und eine Prozessoreinheit (12) aufweist, wobei die Prozessoreinheit (12) mit der mindestens einen Kommunikationsschnittstelle (26) und der mindestens einen Ausgabeschnittstelle (24) in datentechnischer Verbindung steht, **dadurch gekennzeichnet, dass** die Prozessoreinheit (12) zum Empfangen eines signierten ersten Zeitsignals an einem ersten Zeitpunkt und eines signierten zweiten Zeitsignals an einem zweiten Zeitpunkt über die mindestens eine Kommunikationsschnittstelle (26) von einer außerhalb des Gehäuses (11) angeordneten Zeitmessvorrichtung ausgebildet ist, wobei der erste Zeitpunkt vor dem zweiten Zeitpunkt liegt, wobei die Prozessoreinheit (12) zum Empfangen von Messwerten (32) von der mindestens einen Messeinheit (14), die außerhalb des Gehäuses (11) angeordnet ist, über die mindestens eine Kommunikationsschnittstelle (26) zwischen dem ersten und zweiten Zeitpunkt ausgebildet ist, und wobei die Prozessoreinheit (12) zum Signieren der empfangenen Messwerte (32) und zum Bereitstellen der signierten Messwerte (34) über die Ausgabeschnittstelle (24) ausgebildet ist, wobei Ausgabeschnittstelle (24) logisch rückwirkungsfrei ausgebildet ist.

2. Vorrichtung nach Anspruch 1, **dadurch gekennzeichnet, dass** die Prozessoreinheit (12) weiter zum Authentifizieren von Kundendaten, Beginnen und Beenden der Abgabe von Energie, einem Energieträger und/oder einem Medium an ein Fahrzeug und zum Signieren der Messwerte (34) ausgebildet ist.

3. Vorrichtung nach einem der Ansprüche 1 bis 2, **dadurch gekennzeichnet, dass** die Ausgabeschnittstelle (24) zum datentechnischen Verbinden mit einer Anzeigeeinheit (16) ausgebildet ist, wobei die Prozessoreinheit (12) zum Übermitteln von Messwerten (32) über die Ausgabeschnittstelle (24) an eine Anzeigeeinheit (16) ausgebildet ist.

4. Vorrichtung nach einem der Ansprüche 1 bis 3, **dadurch gekennzeichnet, dass** die Ausgabeschnittstelle (24) zum datentechnischen Verbinden mit externen Datenspeicher (20) ausgebildet ist, wobei die Prozessoreinheit (12) zum Übermitteln von signierten Messwerten (34) über die Ausgabeschnittstelle (24) an einen externen Datenspeicher (20) ausgebildet ist.

5. Vorrichtung nach einem der Ansprüche 1 bis 4, **dadurch gekennzeichnet, dass** die Vorrichtung (10) einen internen Datenspeicher (17) umfasst, wobei der interne Datenspeicher (17) im Gehäuse (11) angeordnet ist und mit der Prozessoreinheit (12) in datentechnischer Verbindung steht, wobei der interne Datenspeicher (17) ein digitales Schlüsselpaar bestehend aus einem öffentlichen digitalen Schlüssel und einem privaten digitalen Schlüssel zum Signieren der Messwerte (32) aufweist.

6. Vorrichtung nach einem der Ansprüche 1 bis5, **dadurch gekennzeichnet, dass** die Vorrichtung (10) ein Zählmodul (15) zum Zählen der Ladevorgänge aufweist, das in datentechnischer Verbindung mit der Prozessoreinheit (12) steht, wobei das Zählmodul (15) jedem Abgabevorgang eine eindeutige Zahl zuweist, wobei die Prozessoreinheit (12) zum Übermitteln der Zahl mit den Messwerten (32) eines Abgabevorgangs über die Ausgabeschnittstelle (24) ausgebildet ist.

7. Vorrichtung nach Anspruch 6, **dadurch gekennzeichnet, dass** das Zählmodul (15) einen Panginierungszähler aufweist, wobei der Panginierungszähler Zahlen als digitalen Text ausgibt.

8. Vorrichtung nach einem der Ansprüche 1 bis 7, **dadurch gekennzeichnet, dass** die Prozessoreinheit (12) in dem Gehäuse (11) angeordnet ist, wobei das Gehäuse (11) vorzugsweise plombiert ist.

9. Vorrichtung nach einem der Ansprüche 1 bis 8, **dadurch gekennzeichnet, dass** die Kommunikationsschnittstelle (26) zum datentechnischen Verbinden mit einer Steuer-Prozessoreinheit (22) ausgebildet ist, wobei die Prozessoreinheit (12) zum Empfangen eines Startsignals (28) zum Starten des Abgabevorgangs über die Kommunikationsschnittstelle (26) von der Steuer-Prozessoreinheit (22) und zum Steuern der Messeinheit (14) ausgebildet ist.

10. Vorrichtung nach Anspruch 9, **dadurch gekennzeichnet, dass** die Prozessoreinheit (12) ein Startsignal (30) zum Starten einer Messung über die Kommunikationsschnittstelle (26) an die Messeinheit (14) bereitstellt und das erste Zeitsignal empfängt, wenn die Prozessoreinheit (12) ein Startsignal (28) zum Starten des Abgabevorgangs empfängt.

11. Vorrichtung nach einem der Ansprüche 1 bis 10, **dadurch gekennzeichnet, dass** die Prozessoreinheit (12) zum Ausgeben des ersten Zeitsignals und des zweiten Zeitsignals über die Ausgabeschnittstelle (24) ausgebildet ist.

12. Vorrichtung nach einem der Ansprüche 1 bis 11, **dadurch gekennzeichnet, dass** die Vorrichtung (10) eine Erfassungseinheit (19) zum Erfassen der Anwesenheit eines Fahrzeugs an der Messeinheit (14) aufweist, wobei die Prozessoreinheit (12) zum Empfangen eines signierten dritten Zeitsignals bei Beginn der Erfassung einer Anwesenheit und eines signierten vierten Zeitsignals bei Ende der Erfassung der Anwesenheit ausgebildet ist.

13. Computerimplementiertes Verfahren zum Signieren von Messwerten mindestens einer Messeinheit zum Messen, insbesondere von abgegebener Energie, Energieträger und/oder Medien für ein Fahrzeug mittels einer Vorrichtung nach einem der vorhergehenden Ansprüche, wobei das Verfahren (100) die folgenden Schritte aufweist:
- Empfangen (102) eines signierten ersten Zeitsignals zu einem ersten Zeitpunkt und eines signierten zweiten Zeitsignals zu einem zweiten Zeitpunkt über die mindestens Kommunikationsschnittstelle mittels einer Prozessoreinheit, die innerhalb eines Gehäuses angeordnet ist;
- Empfangen (104) von Messwerten von der mindestens einen Messeinheit, die außerhalb des Gehäuses angeordnet ist, über die mindestens eine Kommunikationsschnittstelle zwischen dem ersten und zweiten Zeitpunkt mittels der Prozessoreinheit;
- Signieren (106) der empfangenen Messwerte mittels der Prozessoreinheit; und
- Bereitstellen (108) der signierten Messwerte über die mindestens eine Ausgabeschnittstelle mittels der Prozessoreinheit.

14. Computerprogrammprodukt mit auf einem Computer ausführbaren Instruktionen, welche auf einem Computer ausgeführt den Computer dazu veranlassen, das Verfahren nach Anspruch 13 durchzuführen.
